# EUROPÄISCHE PATENTANMELDUNG

(11) **EP 2 216 832 A2**
(43) Veröffentlichungstag der Anmeldung: **11.08.2010**
(21) Anmeldenummer: 10152747.1
(22) Anmeldetag: 05.02.2010
(51) Int. Cl.: H01L 31/18, H01L 31/032, H01L 31/07, H01L 31/0392, H01L 31/048, H01L 27/142

(54) **Verfahren zur Herstellung eines Dünnschicht-Photovoltaik-Systems und Dünnschicht-Photovoltaik-System**

(30) Priorität: 06.02.2009 DE 102009007908
(71) Anmelder: Zylum Beteiligungsgesellschaft mbH & Co. Patente II KG, 12529 Schönefeld / Waltersdorf (DE)
(72) Erfinder: Ostermann, Dieter, 41468, Neuss (DE)
(74) Vertreter: Zech, Stefan Markus

(57) **Zusammenfassung**

Beschrieben wird ein Verfahren zur Herstellung eines Dünnschicht-Photovoltaik-Systems (2) mit einer flächigen Metallchalkogenid-Verbindungshalbleiterschicht (7) als Absorber für Sonnenlicht und einer auf der Metallchalkogenid-Verbindungshalbleiterschicht (7) aufgebrachten Metallschicht (8), wobei die Metallchalkogenid-Verbindungshalbleiterschicht (7) und die Metallschicht (8) an ihrer Kontaktfläche einen Schottky-Kontakt ausbilden. Die beschriebene technische Lösung zeichnet sich dadurch aus, dass die Metallchalkogenid-Verbindungshalbleiterschicht (7) durch Aufbringen einer Dispersion, die nanoskalige Partikel mit einem Durchmesser von ca. 3 bis 30 nm enthält, auf ein transparentes Substratmaterial (12) hergestellt wird, wobei die Schichtstärke der auf das Substratmaterial aufgebrachten Metallchalkogenid-Verbindungshalbleiterschicht (7) ca. 150 nm bis ca. 2500 nm beträgt.

## Beschreibung

Die Erfindung betrifft ein Verfahren zur Herstellung eines Dünnschicht-Photovoltaik-Systems, ein Dünnschicht-Photovoltaik-System sowie dessen Verwendung, insbesondere in einem Photovoltaikmodul zur Umwandlung von Solarenergie in elektrische Energie.

Aus der DE 10 2004 012 303 B3 ist eine Reaktionszelle zur photoelektrochemischen Produktion von Wasserstoffgas bekannt. Bei der beschriebenen technischen Lösung ist ein mit einem wässrigen Elektrolyten gefülltes Gehäuse vorge-sehen, in dem eine erste aus einem dotierten Halbleitermaterial, bspw. TiO₂ oder SrTiO₃, bestehende Elektrode und eine zweite, aus einem Edel- oder Halbedelmetall oder einem gegenüber der ersten Elektrode entgegengesetzt dotierten Halbleiter bestehende Elektrode vorgesehen sind. Die beiden Elektroden sind elektrisch leitend miteinander verbunden und werden im Betrieb von einer Lichtquelle bestrahlt. Die Elektroden sind derart angeordnet, dass die Reaktionszelle in zwei Kammern geteilt wird, die ionenleitend miteinander verbunden sind. Über eine Gasaustrittsöffnung wird der sich innerhalb der Reaktionkammer bildende Wasserstoff abgeführt.

Ferner beschreibt die EP 1 232 530 B1 ein Halbleeiterbauelement zur Detektion von UV-Strahlung. Hierbei ist ein Halbleiter als Substrat vorgesehen, das ein Metallchalkogenid-Verbindungshalbleitermaterial als optisches Absorbermaterial für UV-Strahlung aufweist, wobei der Halbleiter mit einem Metall einen Schottky-Kontakt ausbildet. Der derart mit einer nanokristallinen Metallchalkogenid-Verbindungshalbleiterschicht versehene Halbleiter ist auf einer Seite leitend mit einer elektrischen Kontaktschicht oder mit einem metallischen Substrat verbunden und auf der anderen Seite mit einer für UV-Strahlung zumindest teilweise transparenten Metallschicht.

Ein weiteres aus Metallchalkogenid-Verbindungshalbleiterschicht (TiO₂) und Metallschicht bestehendes PV(Photovoltaik)-System ist in der WO 2009/0112397 A2 beschrieben. Kern der dort beschriebenen Erfindung ist eine oberflächlich nanostrukturierte Silberschicht, in der bei Einfall sichtbaren Lichts eine Plasmonenresonanz induziert wird. Praktische Untersuchungen haben jedoch ergeben, dass diese nicht wirksam zur Ladungsträgertrennung beiträgt, da die induzierte Schwingung sich parallel und nicht senkrecht zur Ausdehnung der Schottky-Barriere zwischen Silberschicht und TiO₂-Schicht erstreckt. Ferner wird eine Plasmonenresonanz nur bei exakt eingestelltem Einfallswinkel des eingestrahlten Lichts erreicht.

Ausgehend von dem bekannten Stand der Technik liegt der Erfindung die Aufgabe zugrunde, ein vergleichsweise einfaches und kostengünstiges Verfahren zur Herstellung eines Dünnschicht-Photovoltaik-Systems anzugeben, der sich zum Einsatz in einer Solarzelle eignet. Ziel ist es, auf möglichst effektive und kostengünstige Weise großflächige PV-Module erzeugen zu können.

Die vorgenannte Aufgabe wird durch ein Verfahren zur Herstellung eines Dünnschicht-Photovoltaik-Systems nach dem Oberbegriff des Patentanspruches 1 dadurch gelöst, dass die Metallchalkogenid-Verbindungshalbleiterschicht durch Aufbringen einer nanoskalige Partikel mit einem Durchmesser von ca. 3 bis ca. 30 nm enthaltenden Dispersion auf ein transparentes Substratmaterial, hergestellt wird, wobei die Schichtstärke der auf das Substratmaterial aufgebrachten Metallchalkogenid-Verbindungshalbleiterschicht ca. 150 nm bis ca. 2000 nm beträgt.

Die Erfindung zeichnet sich somit durch eine Modifikation des aus dem Stand der Technik bekannten Schichtaufbaus und dessen geeignete Integration in bekannte technische Lösungen für die Herstellung von Solarmodulen aus.

Das Verfahren ist vergleichsweise leicht durchführbar und ermöglicht die kostengünstige Herstellung von - auch großflächigen - PV-Modulen. Durch Auswahl vergleichsweise kostengünstiger Materialien, wie Palladium (anstelle von Platin), können die Produktionskosten weiter gesenkt werden.

Vorteilhafte Ausgestaltung des erfindungsgemäßen Verfahrens bzw. des daraus hergestellten Dünnschicht-Photovoltaik-Systems finden sich in den Unteransprüchen.

Im Folgenden wird die Erfindung ohne Beschränkung des allgemeinen Erfindungsgedankens anhand von in Figuren dargestellten Ausführungsbeispielen näher erläutert: Es zeigen:
- Fig. 1:: schematische Draufsicht auf ein Dünnschicht-PV- System auf Basis einer Monozelle mit dem photosensitiven Bereich und einem TCO (transparent conductive oxide) Anschluß und einem Abschluß des metallischen Schottky-Kontakt Anschlusses,
- Fig. 2:: schematischer Querschnitt durch das Dünnschicht-PV- System aus Fig. 1,
- Fig. 3:: schematischen Querschnitt durch eine Dünnschicht- PV-Multizelle, die drei in Serie, geschaltete Einzelzellen aufweist,
- Fig. 4:: schematische Draufsicht auf ein Dünnschicht-PV- System in Serienschaltung,
- Fig. 5:: schematische Draufsicht auf ein Dünnschicht-PV- System in Serien- und Parallelschaltung,
- Fig. 6:: schematische Draufsicht auf ein Dünnschicht-PV- System in Serien- und Parallelschaltung mit Bypassdioden,
- Fig. 7:: schematischer Querschnitt durch eine Dünnschicht- PV-Doppelzelle,
- Fig. 8:: schematischer Querschnitt durch eine Dünnschicht- PV-Anordnung in der Ausführung eines Laminatverbundes mit einer Haftverbundfolie,
- Fig.9:: schematischer Querschnitt durch eine Dünnschicht- PV-Anordnung in einem Isolierglasverbund mit einer rückseitigen Glasscheibe,
- Fig. 10:: eine Strom-Spannungskennlinie einer flächigen dotierten TiO₂-Schicht von typisch 150 nm auf einem Glassubstrat mit TCO Beschichtung (Tec-Glas von Pilkington) und einer dünnen Platin-Schottky- Elektrode mit 20 nm Schichtdicke.

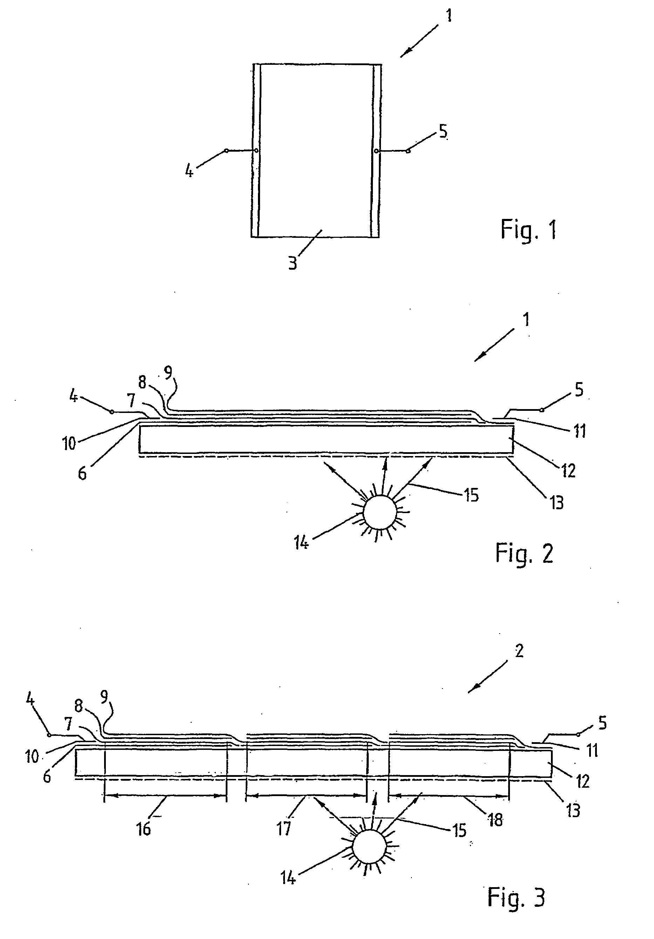

Figur 1 zeigt eine schematische Draufsicht auf ein einfaches Dünnschicht-PV-System (1) auf Basis einer Monozelle mit dem photosensitiven Bereich (3) und dem TCO (transparent conductive oxide) Anschluß (4) und einem metallischen Schottky-Kontakt (5).

Wird als Halbleitermaterial n-dotiertes TiO₂ mit einer dünnen Platin-Schottky-Elektrode gewählt, ist auf diese Weise an den Anschlüssen (4, 5) eine Spannung von etwa 0,4 Volt erreichbar. Bei einem typischen Wirkungsgrad von 3 bis 12% ist eine derartige Monozelle nicht für großflächige Formate geeignet, da übliche TCO-Schichten (ITO (indium tin oxide), ATO (antimony tin oxide), FTO (fluorine doped tin oxide), ZnO (Zikoxid), semitransparente metallische Dünnschichten aus Gold, Dünnschichten auf Basis Single-Wall-Carbon-Nanotubes oder Silber-Wire-Dünnschichten) vergleichsweise hohe Flächenwiderstände aufweisen und nur bei gleichzeitig geringere Transparenz für Tageslicht Werte unter 10 Ω/m² erreichen.

Das TEC Glas # 8/3 der Firma Pilkington Specialty Glass Products, Toledo, OH 43697-0799, USA weist beispielsweise einen elektrischen Flächenwiderstand von ≤ 9 Ω/m² mit einer Tageslicht-Transmittanz von 77% auf.

Da bei der gewählten Schottky-Kontakt PV-Lösung eine Elektrodenseite möglichst für Sonnenlicht transparent gestaltet werden muss, ist es gerade bei großen Zellen erforderlich, diese hinsichtlich einer verbesserten elektrischen Leitfähigkeit bei gleichzeitig möglichst geringer Reduzierung der Durchlässigkeit von Sonnenlicht zu optimieren.

Dabei helfen vorzugsweise so genannte Busbars, also elektrisch hoch leitfähige Leitungen, die üblicherweise im Randbereich angeordnet werden, die Strombelastung zu reduzieren.

Busbars in Form von Silber-, Silber-Aluminium- oder Aluminiumpasten werden je nach erforderlichem Design mittels Siebdruck, Schablonendruck, Dispenser, InkJet, Aerosol-Jet oder Pinsel aufgetragen werden anschließen einer Temperaturbehandlung unterzogen. Übliche Busbarsysteme sind in der Lage Ströme im Ampere-Bereich bis zu einigen 10 Ampere je nach Dicke und Breite des Busbars ohne wesentliche Erwärmung zu leiten.

In Figur 1 sind schematisch ein Busbar links zur Kontaktierung der TCO-Schicht mit dem Anschluß 4 dargestellt und ein Busbar rechts zur Kontaktierung des metallischen Schottky-Kontaktes mit dem Anschluß 5. Grundsätzlich können jedoch viele Arten von Busbar-Ausführungen verwendet werden. Es kann die TCO-Schicht an zwei gegenüberliegenden Busbars und die metallische Schicht an den zwei 90° versetzen gegenüberliegenden Kanten kontaktiert werden und es kann die TCO-Schicht an allen vier Kanten mit einem Busbar versehen werden und die metallische Schicht kann flächig rückseitig elektrisch kontaktiert werden.

In Figur 2 wird ein schematischer Querschnitt durch ein einfaches Dünnschicht-PV-System 1 aufgezeigt. Dabei kann ein Glassubstrat 12 mit einer pyrolytisch aufgebrachten TCO-Schicht 6 verwendet werden, wie beispielsweise das TEC Glas # 8/3 oder 15/3.3 oder 15/4 der Firma Pilkington Specialty Glass Products, oder es können im Vakuum elektrisch leitfähig und weitgehend transparent beschichtete Gläser verwendet werden oder es können SolGel- oder Galvank-TCO-Beschichtungssysteme verwendet werden.

Die TCO-Schicht 6 wird im rechten Randbereich mittels Laserablation oder Schleifen oder Sandstrahlen oder Ätzen entfernt (d.h. die Schicht wird strukturiert), bevorzugt mittels Laserablation oder Ätzen, da derartige Prozesse keine Mikrorisse verursachen und da ein Laserablationsprozess zur Zeit bereits mit 10 bis 100 cm²/sec Ablationsgeschwindigkeit durchführbar ist und sehr gut auf die zu ablatierende Schicht beziehungsweise Schichtfolge eingestellt werden kann. Dies gilt ebenso für die ätztechnische Strukturierung.

Als alternatives Herstellverfahren (nicht in Fig. 2 dargestellt) können auf ein Glassubstrat zuerst die beiden Busbar-Kontaktlinien 10, 11 aufgebracht werden und anschließend wird die TCO-Schicht 6 vollflächig aufgebracht und mittels beispielsweise Laserablation oder Ätzen strukturiert.

Anschließend wird die nanokristalline halbleitende Dünnschicht 7 auf Basis eines Halbleiters der Gruppe TiO₂, TiO₂, SrTiO₃, Cu₂S, ZnO, WO₃, CdS, MoS₂, CdSeS, SnO₂, Pb₃O₄, CdSe, bevorzugt TiO₂, aufgetragen. Die Trocken-Schichtstärke beträgt erfindungsgemäß 150 nm bis ca. 2500 nm, bevorzugt jedoch 500 nm bis 1000 nm. Als Herstellverfahren kann im Labormaßstab Dipcoating zum Einsatz kommen. Bei größeren Flächen wird Rakeln, Rollenbeschichtung, Vorhanggießen, Drucken oder Sprühen als Beschichtungsverfahren bevorzugt. Auch diese Schicht muss strukturiert hergestellt werden. Dies kann durch eine vorhergehende Abdeckung der Busbar-Bereiche (10, 11) erfolgen oder einer nachträglichen ätztechnischen Strukturierung oder lasertechnischen Ablation.

Auf die halbleitende Dünnschicht 7 wird nunmehr der metallische Schottky-Kontakt 8 in der Form einer dünnen Schicht von einigen 10 nm auf Basis eines Metalls aus der Gruppe Ru, Rh, Pd, Ag, Os, Ir, Pt, Au, Al, Cr, Cu, Ni, Mo, Pb, Ta, W, insbesondere Pt, Pd, Au oder Ni, aufgebracht. Von den genannten Metallen wurden bevorzugt mit Platin, Gold, Palladium und Nickel Versuche durchgerührt.

Auch diese Schicht muss strukturiert werden. Hierfür kann ein Maskier-Ätztechnik Verfahren oder ebenfalls Laserablation verwendet werden. Als Herstellverfahren ist ein Vakuum-Verfahren im Sinne eines Sputtervorgangs oder eines Aufdampfvorganges sehr gut geeignet, da lediglich einige wenige 10 nm Schichtstärke erforderlich sind. Es können jedoch eine Reihe weiterer Verfahren wie eine chemische bzw. galvanischen Abscheidung zum Einsatz kommen.

Diese Metallschicht 8, die auch als Schottky-Elektrode bezichnet werden kann, kann grundsätzlich bei einer schmalen Ausführungsform mit dem Busbar 11 verbunden werden. Das wesentliche Kriterium dabei ist der Spannungsabfall aufgrund eines zu hohen Flächenwiderstandes. Üblicherweise wird aus Kosten- und Funktionsgründen eine verstärkende und gut elektrisch leitfähige zweite Schicht 9 auf der Elektrode 8 angeordnet. Diese zusätzliche Schicht 9 muss ebenfalls strukturiert ausgeführt werden. Die Strukturierung kann mittels Maskier-Ätztechnik oder mittels Laser-Ablation erfolgen. Die zweite Schicht 9 kann alternastiv mittels Siebdruck, Schablonendruck, Dispensen, InkJet oder AerosolJet hergestellt werden.

Das Glassubstrat 12 wird in Figur 2 von unten mit der Sonnenbestrahlung 15 der Sonne 14 bestrahlt. Um die Reflektion der einfallen Lichtstrahlen 15 zu reduzieren kann das Glassubstrat 12 mit einer Antireflektionsoberfläche 13 in der Form einer prismierten Oberfläche oder Antireflexbeschichtung versehen werden.

Die photovoltaisch generierte Spannung von typisch etwa 0,4 Volt kann an den Busbars 10,11 mit der Kontaktierung 4, 5 abgegriffen werden.

Das Glassubstrat 2 wird üblicherweise in der Form eines getemperten Floatglas beziehungsweise in der Form eines teilvorgespannten Glases (TVG) oder eines Einscheibensicherheitsglases (ESG) eingesetzt. Neben einem üblichen Floatglas werden eine eisenoxidarmes Weißglas beziehungsweise Solarglas bevorzugt verwendet.

Figur 3 zeigt ein Schematischer Querschnitt durch eine Dünnschicht-PV-Multizelle 2 bestehend aus drei in Serie geschaltete Einzelzellen 16, 17, 18. Bei der Verwendung einer schmalen Breite der Einzelzelle 16, 17, 18 kann die zusätzliche metallische Schicht 9 entfallen und die metallische Schicht 8 kann die Serienverschaltung (nicht im Detail dargestellt) übernehmen. Die Anzahl der in Serie geschalteten Zellen kann auf den jeweiligen Anwendungsfall abgestimmt ausgeführt werden.

Auch bei dem Ausführungsbeispiel gemäß Figur 3 können die Busbars 10, 11 vor der Anbringung der TCO-Schicht 6 aufgebracht werden. Der Busbar 11 kann auch grundsätzlich entfallen, wenn die metallisch gut leitfähige zweite Schicht 9 die Busbar-Funktion übernimmt, wie in Fig. 3 dargestellt.

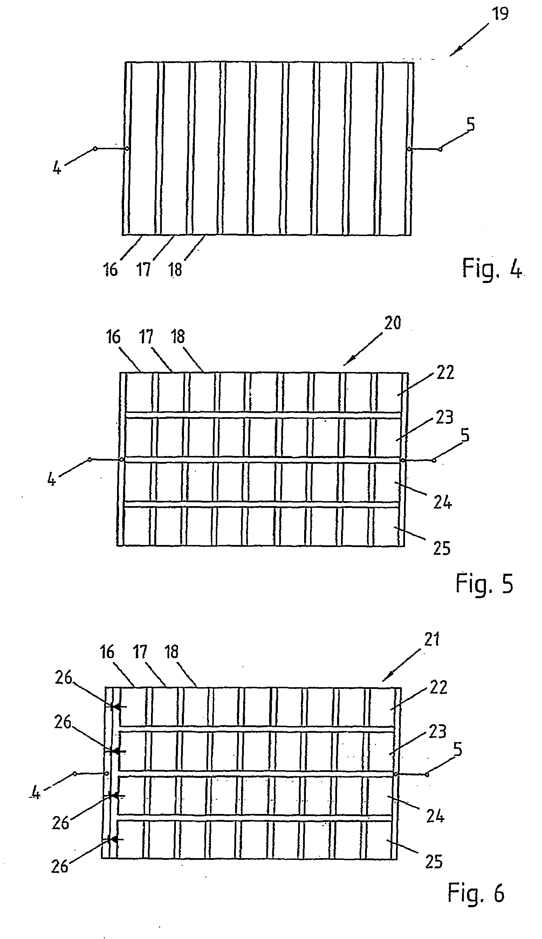

Figur 4 zeigt eine schematische Draufsicht auf ein Dünnschicht-PV-System in Serienschaltung 19. In dieser Ausführungsform werden längliche Zellen 16, 17, 18 in Serie, wie in Figur 3 dargelegt, verwendet. Die Anzahl der Zellen kann dabei auf die jeweilige Anwendung und die geforderte Spannung angestimmt werden. Je schmaler die einzelnen Zellen ausgeführt werden, desto geringere Anforderungen werden an die elektrische Leitfähigkeit der TCO-Schicht 6 gestellt. Auch an die elektrische Leitfähigkeit der Schichten 8, 9 werden dann weniger Anforderungen gestellt.

Figur 5 zeigt eine schematische Draufsicht auf ein Dünnschicht-PV-System in Serien- und Parallelschaltung (20).

Dabei werden die vertikal gezeichneten Zellen 16, 17, 18 in Zellenlinien 22, 23, 24, 25 getrennt und die Zellenlinien 22, 23, 24, 25 werden in Serie geschaltet und dann an den Breitseiten mit den Kontakten 4, 5 kontaktiert. Die Anzahl der Spalten 16, 17, 18 und die Anzahl der Zeilen 22, 23, 24, 25 kann auf die jeweilige Anwendung abgestimmt werden. Die Gesamtspannung, die an den Kontakten 4, 5 abgegriffen werden kann, wird durch die Anzahl der Spalten 16, 17, 18, also der Anzahl in Serie geschalteter Zellen bestimmt. In dieser Ausbildung müssen die einzelnen Zellen sehr gleichmäßig und mit geringer Streuung in den wesentlichen Parametern hergestellt werden, da die Gefahr des Rückwärtsstroms und damit einhergehend der Zerstörung von Zellen gegeben ist.

Figur 6 zeigt eine schematische Draufsicht auf ein Dünnschicht-PV-System in Serien- und Parallelschaltung mit Bypassdioden 26.

In dieser Ausführungsform wird eine von vielen möglichen Schutzmöglichkeiten gegen die Zerstörung von Zellen aufgrund von Rückwärtsströmen angegeben und werden deshalb sogenannte Bypassdioden 26 in die in Serie geschalteten Zellen 22, 23, 24, 25 geschaltet. Schematisiert sind die Schutzdioden beziehungsweise Bypassdioden 26 auf dem Glassubstrat dargestellt. Grundsätzlich können diese Dioden 26 in der Form von SMD-Dioden 26 direkt auf dem Glas kontaktiert werden, sie können jedoch ebenso getrennt vom Glas angewendet werden und müssten in diesem Fall die einzelnen in Serie geschalteten Zellen mit getrennten Kontaktierungen versehen werden.

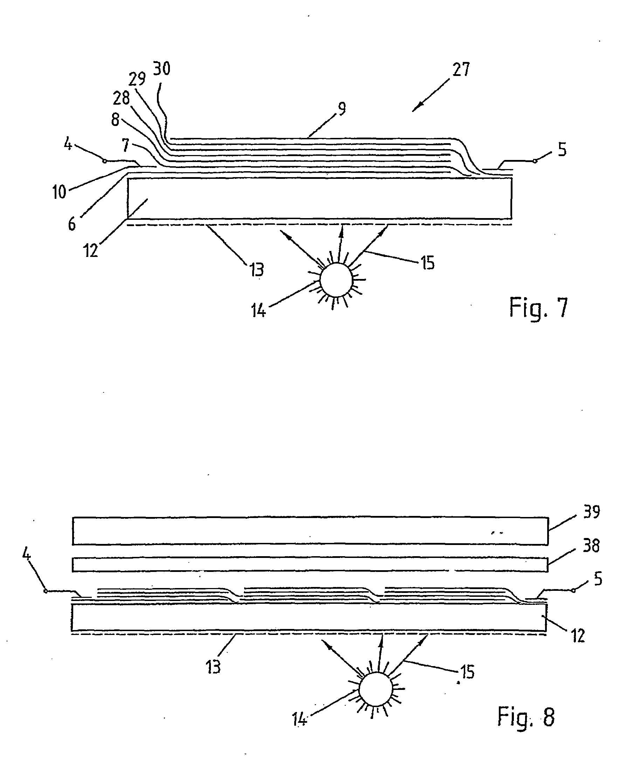

Figur 7 zeigt einen schematischen Querschnitt durch eine Dünnschicht-PV-Doppelzelle 27.

Grundsätzlich sind in der Dünnschicht-PV Anordnung unter Nutzung des Schottky-Dioden Effektes und der möglichen Paarungen Halbleiter zu Metall nur geringe Spannungen erzielbar.

Bei dem bevorzugt eingesetzten System TCO-TiO₂(n-dotiert)-Pt werden etwa 0,4 Volt photovoltaisch erzeugt. Derartige Spannungen sind für viele Anwendungen zu gering und bewirken üblicherweise hohe Ströme, die mit üblichen Dünnschichtstrukturen schwierig zu verarbeiten sind.

Da alle diese flächigen Schottky-Dioden Schichten extrem dünn sind, stellt die in z-Richtung übereinander angeordnete Doppelzelle eine relativ einfache Möglichkeit dar, die Zellspannung durch die Serienschaltung dieser beiden übereinander angeordneten Zellen zu erhöhen und natürlich auch damit den Wirkungsgrad, wobei die Mehrkosten im Verhältnis als gering zu bewerten sind.

Grundsätzlich ist auch eine Verdreifachung in Analogie zu dieser Verdoppelung möglich und würden damit an den Kontakten 4, 5 bis zu 1,2 Volt zur Verfügung stehen. Es versteht sich, dass bei einer derartigen Stapelung der PV-Systeme diese hinreichend transparent ausgebildet sein müssen, so dass auch das vom eingestrahlten Licht abgewandte System noch Strahlung absorbieren kann.

In der Doppelzellenvariante 27 wird zusätzlich auf die erste Metallschicht 8 der ersten Zelle eine zweite TCO-Schicht 28 angeordnet zwecks Verbesserung der elektrischen Leitfähigkeit und auf dieser Schicht wird die zweite halbleitende Schicht 29 und die zweite Metallschicht 30 angeordnet und die bisher übliche elektrisch gut leitende zweite Metallschicht 9 wird wie bei der Einfachzelle bis zum Kontakt 5 beziehungsweise einem allfälligen Busbar 11 geführt.

Da üblicherweise die bevorzugten halbleitend ausgebildeten nanoskaligen TiO₂-Schichten eine gute Absorption im UV-Bereich aufweisen, ist bei der Wahl der metallischen Schichten auf eine möglichst geringe UV-Absorption zu achten beziehungsweise wird zur Erhöhung des Wirkungsgrades auch ein Glassubstrat 12 mit einer möglichst geringen UV-Absorption gewählt.

Weiterhin kann die Dicke der ersten und der zweiten und gegebenenfalls der dritten halbleitende Schicht 7, 29 an einen gleichmäßigen Energieertrag angepasst werden, so dass die einzelnen.

Die Varianten mit übereinander angeordneten Mehrfachzellen können ebenfalls in Serien- und Parallelschaltungssystemen verwendet werden.

Figur 8 zeigt einen schematischen Querschnitt durch eine Dünnschicht-PV-Anordnung in der Ausführung eines Laminatverbundes mit einer Haftverbundfolie 38.

In dieser Anordnung wird eine Haftverbundfolie 38 in der Form einer Ethylenvinylacetat (EVA) Folie oder einer Polyvinylbutiral (PVB) Folie zwecks Lamination mit einem rückseitigen Substrat 39 vorgesehen. Im kristallinen PV-Modul-Herstellprozess sind üblicherweise EVA Folien mit einem polymeren Sandwichlaminat 39 und einem relativ einfachen Tischlaminator üblich und im Fassadenglasbereich werden üblicherweise zumindest 370 µm dicke oder doppelt und dreifach so dicke PVB Folien in Verbindung mit einem Glassubstrat 39 verwendet. Das Sandwichlaminat 39 kann dabei ein Laminat aus einer dünnen PVF-Folie mit einer dünnen PET-Folie sein und es kann auch noch eine dünne Aluminiumfolie dazwischen als Wasserdampfbarriereschicht angeordnet sein. Als typisches Beispiel einer derartigen Folie wird eine Icosolar-Folie der Firma Isovolta genannt. Der Vorteil der Verwendung eines derartigen Rückseitensubstrates 39 liegt im geringeren Gewicht verglichen mit einem 3 bis 6 mm dicken Glas und im einfacheren Laminierprozess.

Bei Verwendung von einem Rückseitensubstrat 39 in Form von Glas kann eine ESG Verbund realisiert werden und es können damit und mit der Verwendung von PVB als Haftverbundfolie 38 Fassadenelemente in Gebäuden beziehungsweise Vordachelemente oder allgemeine Dachelement und Brüstungselemente realisiert werden. Üblicherweise wird dabei das Glassubstrat 39 in Form eines zumindest teilvorgespannten Glases (TVG) oder eines Einscheibensicherheitsglases (ESG) verwendet.

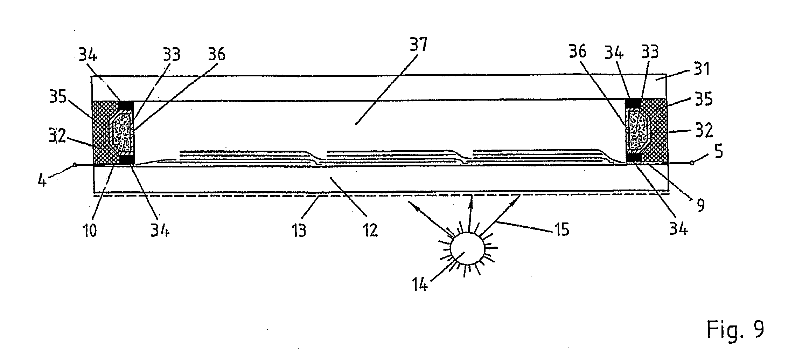

Figur 9 zeigt einen schematischen Querschnitt durch eine Dünnschicht-PV-Anordnung in einem Isolierglasverbund mit einer rückseitigen Glasscheibe 31 aufgezeigt. In dieser Ausführung ist die Dünnschicht-PV-Anordnung auf der Ebene 2 angeordnet, also der Innenseite der Glasscheibe 12. Grundsätzlich kann die Dünnschicht-PV-Anordnung auch auf der Ebene 3, also der Innenseite der Glasscheibe 31 angeordnet werden, allerdings reflektiert dann die Innenseite der Scheibe 12 Licht und wäre diese Seite mit einer Antireflektionsschicht zu versehen, um eine zu starke Reduktion der einstrahlenden Sonnenstrahlen 15 der Sonne 14 zu vermeiden.

Der Isolierglasverbund aus zwei Glasscheiben 12, 31 wird dabei nach dem Stand der Technik hergestellt, also mit einem umlaufenden Abstandshalterprofil 32 mit darin eingefülltem Trocknungsmittel 33 und mit Öffnungen 36 im Abstandshalter zum Isolierglasinnenraum 37.

Der Abstandshalter wird mit einem primären Dichtungsmittel 34 wie Butylen beziehungsweise Polyisobutylen (PIB) mit den beiden Glasscheiben 12, 31 verbunden und mit einem sekundären Dichtungsmittel 35 umlaufend abgeschlossen. Als sekundäres Dichtungsmittel 35 kann Silikon beziehungsweise Polydimetylsiloxane (PDMS) oder Pulyurethane (PU) oder Polysulfid (PS) verwendet werden.

Der Isolierglasinnenraum 37 kann mit einem inerten Edelgas wie Argon oder Xenon oder Krypton mit dem Druck befüllt sein, der auch außerhalb des Isolierglassystems gegeben ist. Die Anschlüsse 4, 5 können mittels der Busbar-Systeme 10, 11 auch in mehrfacher Ausführung hergestellt werden. Dabei ist darauf zu achten, dass keine Wasserdampfdiffusion zwischen den Busbar-Leitungen und dem Glas gegeben ist. Ferner sollten unterhalb der primären und sekundären Dichtmittel 34, 35 alle Schichten 6, 7, 8, 28, 29, 30 entfernt werden, da derartige Schichten unterwandert werden können und eine Diffusion von Wasserdampf in den Isolierglasinnenraum 37 stattfinden kann.

In einer Weiterbildung dieses Isolierglas-Dünnschicht-PV-Systems kann anstelle des Glases 12 ein Verbund-Sicherheits-Glas-Dünnschicht-PV-System wie in Figur 8 skizziert verwendet werden.

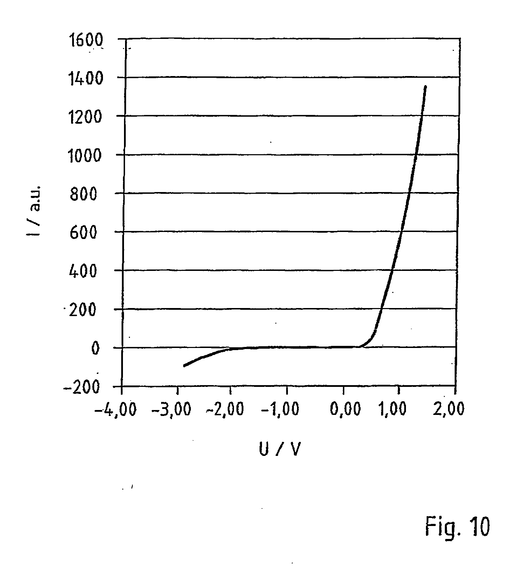

In Figur 10 ist eine Strom-Spannungskennlinie einer flächigen dotierten TiO₂ Schicht von typisch 150 nm auf einem Glassubstrat mit TCO Beschichtung (Tec-Glas von Pilkington) und einer dünnen Platin-Schottky-Elektrode mit 20 nm Schichtdicke dargestellt.

## Patentansprüche

1. Verfahren zur Herstellung eines Dünnschicht-Photovoltaik-Systems (2) mit einer flächigen Metallchalkogenid-Verbindungshalbleiterschicht (7) als Absorber für Sonnenlicht und einer auf die Metallchalkogenid-Verbindungshalbleiterschicht aufgebrachten Metallschicht (8), wobei die Metallchalkogenid-Verbindungshalbleiterschicht (7) und die Metallschicht (8) an ihrer Kontaktfläche einen Schottky-Kontakt ausbilden,
**dadurch gekennzeichnet, dass**
die Metallchalkogenid-Verbindungshalbleiterschicht (7) durch Aufbringen einer nanoskalige Partikel mit einem Durchmesser von ca. 3 bis ca. 30 nm enthaltenden Dispersion auf ein transparentes Substratmaterial (12), hergestellt wird, wobei die Schichtstärke der auf das substratmaterial aufgebrachten Metallchalkogenid-Verbindungshalbleiterschicht (7) ca. 150 nm bis ca. 2500 nm beträgt.

2. Verfahren nach Anspruch 1,
**dadurch gekennzeichnet, dass**
die Schichtstärke der auf das Substratmaterial aufgebrachten Metallchalkogenid-Verbindungshalbleiterschicht (7) ca. 500 nm bis ca. 1000 nm beträgt.

3. Verfahren nach Anspruch 1 oder 2,
**dadurch gekennzeichnet, dass**
die Metallchalkogenid-Verbindungshalbleiterschicht (7) durch Rakeln, Rollenbeschichtung, Vorhanggießen, Drucken oder Sprühen auf das Substratmaterial (12) aufgebracht wird.

4. Verfahren nach einem der Ansprüche 1 bis 3,
**dadurch gekennzeichnet, dass**
als Metallchalkogenid-Verbindungshalbleiterschicht (7) ein Halbleitermaterial der Gruppe TiO₂, SrTiO₃, Cu₂S, ZnO, WO₃, CdS, MoS₂, CdSeS, SnO₂, Pb₃O₄, CdSe, bevorzugt TiO₂, verwendet werden.

5. Verfahren nach einem der Ansprüche 1 bis 4,
**dadurch gekennzeichnet, dass**
die Metallschicht (8) durch ein Metall aus der Gruppe Ru, Rh, Pd, Ag, Os, Ir, Pt, Au, Al, Cr, Cu, Ni, Mo, Pb, Ta, W, insbesondere Pt, Pd, Au oder Ni gebildet wird.

6. Verfahren nach einem der Ansprüche 1 bis 5,
**dadurch gekennzeichnet, dass**
die Dicke der auf die Metallchalkogenid-Verbindungshalbleiterschicht (7) aufgebrachten Metallschicht (8) ca. 10 bis ca. 20 nm beträgt.

7. Verfahren nach einem der Ansprüche 1 bis 6,
**dadurch gekennzeichnet, dass**
auf die Metallschicht (8) auf ihrer von der Metallchalkogenid-Verbindungshalbleiterschicht (7) abgewandten Seite eine zweite verstärkende Metallschicht (9) aufgebracht wird, wobei das Material der zweiten verstärkenden Metallschicht (9) derart gewählt ist, dass sich zwischen der Metallschicht (8) und der verstärkenden Metallschicht (9) ein ohmscher Kontakt ausbildet.

8. Verfahren nach einem der Ansprüche 1 bis 7,
**dadurch gekennzeichnet, dass**
das transparente Substratmaterial (12) ein Glassubstrat, insbesondere ein getempertes oder ein ungetempertes Floatglas als Einscheiben-Sicherheitsglas, ist, wobei das transparente Substratmaterial (12) vorzugsweise auf der mit der Metallchalkogenid-Verbindungshalbleiterschicht (7) zu beschichtenden Seite eine transluzente oder transparente leitfähige Schicht (6), insbesondere eine TCO-Schicht, besonders bevorzugt eine FTO-Schicht, aufweist.

9. Verfahren nach Anspruch 1 bis 8,
**dadurch gekennzeichnet, dass**
eine Mehrzahl von Dünnschicht-Photovoltaik-Systemen modulartig nebeneinander auf ein gemeinsames transparentes Substratmaterial (12) aufgebracht werden, wobei die Mehrzahl von Dünnschicht-Photovoltaik-Systemen vorzugsweise durch Strukturieren eines einheitlich auf das Substratmaterial (12) aufgebrachten Dünnschicht-Photovoltaik-Systems erzeugt wird.

10. Verfahren nach Anspruch 9,
**dadurch gekennzeichnet, dass**
eine Mehrzahl von Dünnschicht-Photovoltaik-Systemen matrixartig auf ein gemeinsames Substratmaterial (12) aufgebracht werden, wobei die Dünnschicht-Photovoltaik-Systeme zeilenweise in Reihe geschaltet werden und spaltenweise parallel geschaltet werden.

11. Verfahren nach einem der Ansprüche 1 bis 10,
**dadurch gekennzeichnet, dass**
eine Mehrzahl von Dünnschicht-Photovoltaik-Systemen übereinander als Stack (27) auf einem gemeinsamen Substratmaterial (12) erzeugt wird.

12. Verfahren nach einem der Ansprüche 1 bis 11,
**dadurch gekennzeichnet, dass**
das Dünnschicht-Photovoltaik-System oder die Mehrzahl von Dünnschicht-Photovoltaik-Systemen mittels einer Haftverbundfolie (38) und einem rückseitigen Substrat (39) zu einer Einheit laminiert wird.

13. Verfahren nach Anspruch 12 und 8,
**dadurch gekennzeichnet, dass**
das rückseitige Substrat (39) ein Glassubstrat aus Floatglas (ungetempert) oder teilvorgespanntem Floatglas (TVG) oder Einscheibensicherheitsglas (ESG) ist und gemeinsam mit dem die Metallchalkogenid-Verbindungshalbleiterschicht (7) tragenden Glassubstratmaterial (12) mittels Autoklavprozess ein Verbundsicherheitsglas (VSG) erzeugt wird.

14. Verfahren nach Anspruch 12,
**dadurch gekennzeichnet, dass**
das rückseitige Substrat (39) aus einem eine dünne PVF-Folie und eine PET-Folie umfassenden polymerem Foliensandwich gebildet wird, wobei eine Aluminium-Folie zwischen diesen beiden Folien als Wasserdampfbarriere eingebaut wird.

15. Verfahren nach Anspruch 1 bis 14,
**dadurch gekennzeichnet, dass**
das Dünnschicht-Photovoltaik-System (2) oder die Mehrzahl von Dünnschicht-Photovoltaik-Systemen im Inneren eines Isolierglasverbundes, insbesondere auf der Innenseite der sonnenseitigen Glasscheibe, angeordnet wird.

16. Dünnschicht-Photovoltaik-System (2) hergestellt nach einem Verfahren nach einem der Ansprüche 1 bis 15.

17. Verwendung eines Dünnschicht-Photovoltaik-Systems (2) nach Anspruch 16 in Gebäudefassaden, im Dachbereich, als Brüstungselement, als Vordach oder freistehend.
